# EUROPEAN PATENT APPLICATION

(11) **EP 1 768 183 A2**
(43) Date of publication of application: **28.03.2007**
(21) Application number: 06254748.4
(22) Date of filing: 12.09.2006
(51) Int. Cl.: H01L 25/065, H01L 23/48, H01L 23/544, H01L 21/68

(54) **Microdevices with bump contacts on two sides and manufacturing method thereof**

(30) Priority: 23.09.2005 US 233367
(71) Applicant: ASML Netherlands BV, 5504 DR Veldhoven (NL)
(72) Inventor: Bijnen, Francisus Godefridus Casper, 5551 SW Valkenswaard (NL); Weenink, Willem Dieter, 5508 TS Veldhoven (NL)
(74) Representative: Roberts, Peter David

(57) **Abstract**

Provided are microdevices, e.g. integrated circuits, with contact bumps and processes for making the same. The microdevices may have contact bumps on two or more sides of the microdevices. Also provided are stacks of microdevices.

## Description

### FIELD OF THE INVENTION

The present invention relates to microdevices.

### BACKGROUND

A lithographic apparatus is a machine that applies a desired pattern onto a substrate, usually onto a target portion of the substrate. A lithographic apparatus can be used, for example, in the manufacture of microdevices such as integrated circuits. A patterning device, for instance a reticle, may be used to generate e.g. a circuit pattern to be formed on an individual layer of the integrated circuit. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Usually, several layers of patterns are provided on a substrate, thereby forming microstructures, e.g. circuits, which are three-dimensional. Once this process has been completed, an integrated circuit thus formed is often "packaged". Packaging may comprise placing the integrated circuit within a plastic casing which is provided with conducting legs. Within the packaging, connections are established between the conducting legs and the circuits of the integrated circuit. There is an ongoing desire to improve the provision of the connection between the conducting legs and the circuits of the integrated circuit.

### SUMMARY

In an embodiment, a microdevice (e.g. an integrated circuit) is provided having at least two sides (e.g. opposing sides) provided with contact bumps.

In an embodiment, a process is provided comprising:
forming a microstructure on a first side of a substrate, said substrate having a second side facing away from said first side;
etching recesses in said second side, said recesses reaching said microstructure;
filling the recesses with metal to provide contact bumps.

Also, a stack of microdevices is provided comprising a first microdevice and a second microdevice, the first and second microdevice being connected through contact bumps.

Furthermore, there is provided a method of fabricating a microdevice, e.g. an integrated circuit, the method comprising:
providing alignment marks on a first side of a substrate;
providing a plurality of patterned layers on a second side of the substrate, the patterned layers together forming a microdevice, the patterned layers being aligned with respect to the alignment marks;
etching recesses on the first side of the substrate, the recesses being aligned with respect to the alignment marks, the recesses being etched through until the first patterned layer is exposed; and
providing contact bumps within the recesses which are in contact with the first patterned layer.

Additionally, there is provided a substrate with a plurality of patterned layers which together form a microdevice, e.g. an integrated circuit, the substrate further being provided with a set of contact bumps located in recesses in the substrate such that they are in electrical contact with an innermost patterned layer.

Also, there is provided a set of three or more substrates sandwiched together, each substrate being provided with a microdevice, e.g. an integrated circuit, and having contact bumps on both sides, thereby allowing adjacent substrates to be in electrical communication with one another, and allowing external connections to be provided to the set of substrates.

### BRIEF DESCRIPTION OF THE DRAWINGS

Embodiments of the invention will now be described, by way of example only, with reference to the accompanying schematic drawings, in which:

Figure 1 illustrates a lithographic apparatus according to an embodiment of the invention;

Figure 2 is a schematic cross section illustrating the substrate table incorporating two branches of an optical system for double side alignment;

Figure 3 is a plan view of a substrate showing the position and orientation of the double side alignment optics;

Figure 4 is a plan view showing an alternative position and orientation of the double side alignment optics;

Figure 5 is a cross section of a portion of a substrate table having integral optical components; and

Figures 6a-6i illustrate a cross section view of a substrate, which illustrates schematically an embodiment of the invention.

Figures 7A and 7B illustrate a schematic representation of stacking microdevices according to an embodiment of the invention.

Figures 8A-8C illustrate a schematic representation of stacking microdevices according to an embodiment of the invention.

### DETAILED DESCRIPTION

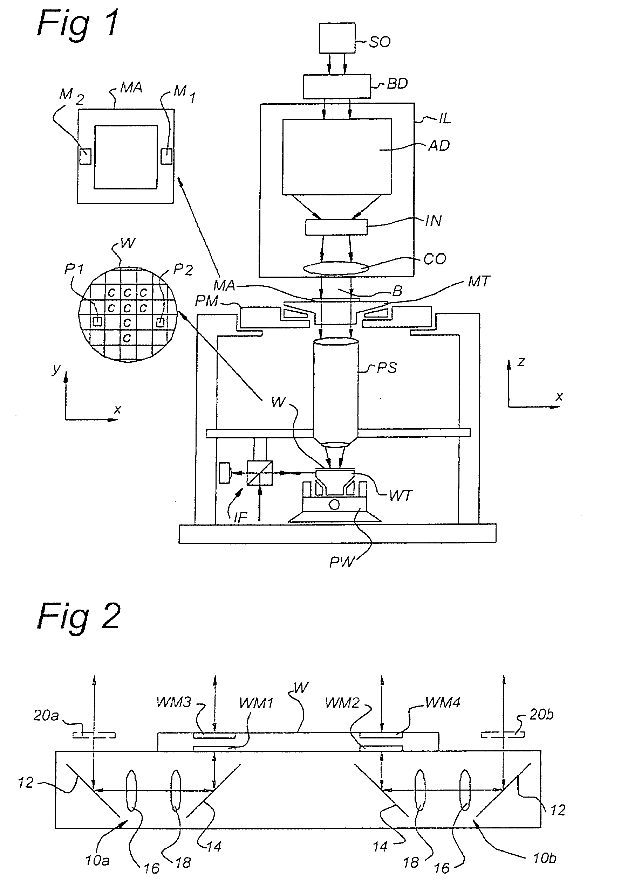

In an embodiment, the present invention provides microdevices with contact bumps. First, Figures 1-5 describe an example of an apparatus that may be used in preparing microdevices according to the present invention.

Figure 1 schematically depicts a lithographic apparatus according to one embodiment of the invention. The apparatus comprises:
- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a substrate table) WT constructed to hold a substrate (e.g. a resist-coated substrate) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as, for example, whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example, with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example, if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

In an exemplary embodiment of the invention, the apparatus is of a transmissive type (e.g. employing a transmissive mask). Alternatively, the apparatus may be of a reflective type (e.g. employing a programmable mirror array or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather means that liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. In an embodiment, a resist layer is provided on the substrate. In an embodiment, the substrate W is a wafer, for instance a semiconductor wafer. In an embodiment, the wafer material is selected from the group consisting of Si, SiGe, SiGeC, SiC, Ge, GaAs, InP, and InAs. In an embodiment, the wafer is a III/V compound semiconductor wafer. In an embodiment, the wafer is a silicon wafer. In an embodiment, the substrate is a ceramic substrate. In an embodiment, the substrate is a glass substrate. Glass substrates may be useful, e.g., in the manufacture of flat panel displays and liquid crystal display panels. In an embodiment, the substrate is a plastic substrate. In an embodiment, the substrate is flexible. In an embodiment, the substrate is transparent (to the naked human eye). In an embodiment, the substrate is colored. In an embodiment, the substrate is absent a color.

With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) may be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks, as illustrated, occupy dedicated target portions, they may be located in spaces between target portions (these are known as scribe-lane alignment marks). Similarly, in situations in which more than one die is provided on the mask MA, the mask alignment marks may be located between the dies.

The depicted apparatus may be used in, e.g., one or more of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-) magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation may be readily applied to maskless lithography that utilizes programmable patterning device, such as a programmable mirror array of a type as referred to above.

Combinations and/or variations on the above described modes of use or entirely different modes of use may also be employed.

Figure 2 shows a substrate W on a substrate table WT. Substrate marks WM3 and WM4 are provided on a first side ("front side") of the substrate W and light may be reflected from these marks, as indicated by the arrows above WM3 and WM4, and used for alignment with marks on a mask in conjunction with an alignment system (not shown). An example of such front side alignment is mentioned in more detail in US patent application publication number 2005-0133743, filed 17 December 2003, which is hereby incorporated by reference in its entirety.

Substrate marks WM1 and WM2 are provided on a second side ("back-side") of the substrate W. In lithography applications, the back-side of the substrate W is here intended to refer to the side of the substrate that is facing away from the side being exposed to radiation. Although the embodiment shown in Figure 2 depicts alignment marks on both sides of the substrate, in an embodiment the marks may be present on only one side of the substrate. For instance, marks on a particular side may first be used as front side marks in front side aligning, and when the substrate is flipped the same marks may be used as backside marks (or *vice versa*)*.*

An optical system is built into the substrate table WT for providing optical access to the substrate marks WM1, WM2 on the back-side of the substrate W. The optical system comprises a pair of arms 10a, 10b. Each arm consists of two mirrors, 12, 14 and two lenses 16, 18. The mirrors 12, 14 in each arm are inclined such that the sum of the angles that they make with the horizontal is 90°. In this way, a beam of light impinging vertically on one of the mirrors will remain vertical when reflected off the other mirror. Of course, other ways of obtaining the 180° change in direction can be thought of. For instance, the lenses and the mounting may be designed in such a way that they may take account of a large part of the direction change, as long as the total of the optical system provides a direction change of 180°.

In use, light is directed from above the substrate table WT onto mirror 12, through lenses 16 and 18, onto mirror 14 and then onto the respective substrate mark WM1, WM2. Light is reflected off portions of the substrate mark and returns along the arm of the optical system via mirror 14, lenses 18 and 16 and mirror 12. The mirrors 12, 14 and lenses 16, 18 are arranged such that an image 20a, 20b of the substrate mark WM1, WM2 is formed at the plane of the front (top) surface of the substrate W, corresponding to the vertical position of substrate marks WM3, WM4 provided on the front side of the substrate W. The order of the lenses 16, 18 and the mirrors 12, 14 may be different, as appropriate to the optical system. For example, lens 18 may be between the mirror 14 and the substrate W (see illustrations of later embodiments).

Images 20a, 20b of substrate marks WM1, WM2 act as virtual substrate marks and may be used for alignment by the pre-existing alignment system (not shown) in exactly the same way as a real substrate mark provided on the front (top) side of the substrate W.

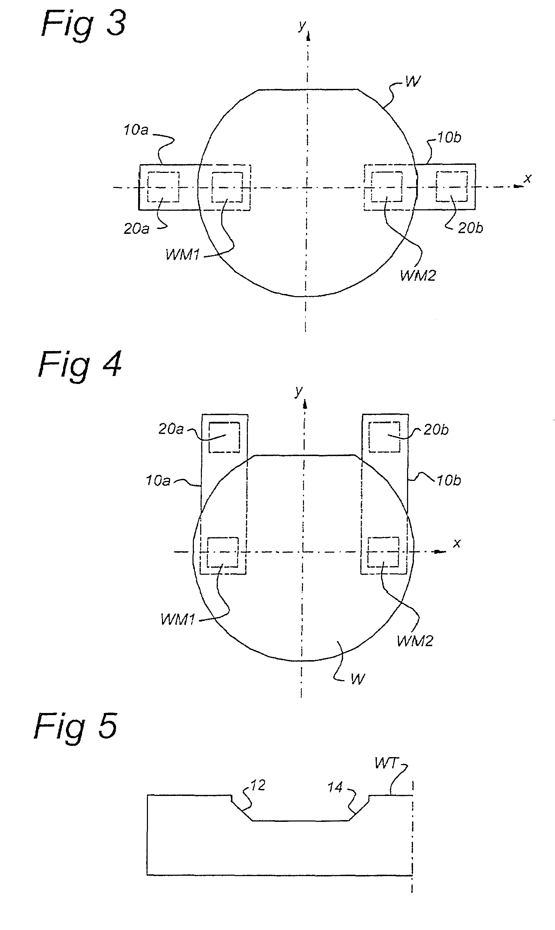

As shown in Figure 2, the arms of the optical system 10a, 10b produce images 20a, 20b which are displaced to the side of the substrate W so that they may be viewed by an alignment system above the substrate W. Two preferred orientations of the arms of the optical system 10a, 10b are shown in Figures 3 and 4, which are plan views of the substrate W, which lies in the XY plane. The substrate table WT is omitted from Figures 3 and 4 for clarity. In Figure 3, the arms of the optical system 10a, 10b are aligned along the X axis. In Figure 4, the arms of the optical system 10a, 10b are parallel to the Y axis. In both cases, the substrate marks WM1, WM2 lie on the X axis. The substrate marks WM1, WM2 are located on the underside of the substrate W, so they are reversed from the point of view of the top side of the substrate W. However, the arrangement of the mirrors 12, 14 of the arms of the optical system may be configured so that the images 20a, 20b of the substrate marks WM1, WM2 are restored to a proper orientation. Thus the images appear exactly the same as if they were on the top side of the substrate W. The optical system also may be arranged so that the ratio of the size of a substrate mark WM1, WM2 to its image 20a, 20b is 1:1, i.e., there is no magnification or reduction. Consequently, the images 20a, 20b can be used exactly as if they were real substrate marks on the front side of the substrate W. A common alignment pattern or key provided on a mask may be used to perform alignment with both real and virtual substrate marks.

In the current example, substrate marks are provided on both the front and back-sides of the substrate W at corresponding positions, as shown in Figure 2. In Figures 3 and 4, only the substrate marks on the back-side of the substrate W are shown, for clarity. According to this arrangement, when the substrate W is flipped over, by rotation about either of the X or Y axes, a substrate mark that was on the top side of the substrate W now may be on the underside of the substrate W, but at a position such that it may be imaged by an arm of the optical system 10a, 10b.

It will be noted that, because of the mirror arrangement, displacement of the substrate W in one direction parallel to an arm 10a, 10b of the optical system will displace the corresponding image 20a, 20b of a substrate mark WM1, WM2 on the under side of the substrate in the opposite direction. For example, in Figure 3, if the substrate W were displaced to the right, the images 20a, 20b would be displaced to the left. Software controlling the alignment system may take this into account when determining the position of the substrate marks WM1, WM2 and when adjusting the relative positions of the substrate W and a mask when performing alignment. If the two arms of the optical system 10a, 10b are symmetric then the separation between the images 20A and 20B will in fact stay constant when the substrate is displaced.

In an alternative embodiment of the invention, a substrate table WT may be provided with a mirror arrangement that does not change the direction of movement of the images 20a, 20b with respect to the movement of the substrate marks WM1, WM2.

At least two substrate marks may be provided on a side of the substrate W. A single mark may provide information about the relative positioning of an image of a specific point on a mask to a specific point on the substrate. However, to ensure the correct orientational alignment and magnification, it is preferable to use at least two marks.

Figure 5 shows a portion of the substrate table WT in cross section. According to one embodiment of the invention, the optical system 10a, 10b for imaging the substrate marks on the back-side of a substrate may be built into the substrate table WT in a particular fashion. As shown in Figure 5, the mirrors 12, 14 of an arm of the optical system may not be provided as discrete components, but may be integral with the substrate table WT. Appropriate faces are machined into the substrate table WT, which may then be provided with a coating to improve reflectivity, thus forming the mirrors 12, 14. The optical system may be made from the same material as the substrate table, such a Zerodur^{™}, which has a very low coefficient of thermal expansion and therefore assists in obtaining good alignment accuracy.

The substrate marks WM1, WM2, WM3, WM4 may be provided on the substrate W in order to allow alignment of the substrate W with respect to the projected patterned beam. Alignment is desirable for proper positioning of different layers of the substrate W with respect to each other. A substrate W may be built up from a plurality of layers that are each formed on the substrate W one after the other and are subject to an exposure. Since the different layers are configured to form a working device, the different exposures should be optimally aligned with respect to each other.

The lithographic apparatus described above in relation to figures 1 to 5 may be used in the fabrication of input/output contacts for microdevices such as integrated circuits. Integrated circuits may be mounted in packaging which comprises a plastic case together with conducting legs. The conducting legs allow the integrated circuit to be easily connected to, e.g., a printed circuit board. An example of packaging is so-called flip chip packaging. In flip chip packaging, lithography is used to provide a set of spheres of solder which protrude from an upper surface of the integrated circuit. The spheres of solder are located at sites which provide electrical contact to the integrated circuit. The integrated circuit is inverted (flipped) and placed onto a base. The base is provided with conducting legs which have contact areas that are arranged to make electrical contact with the spheres of solder. The contact may be made e.g. by heating the solder such that it melts onto the conducting legs of the base. In an alternative arrangement gold may be used instead of solder. Contact between the gold and the conducting legs of the base may be achieved, e.g., by applying pressure to the gold.

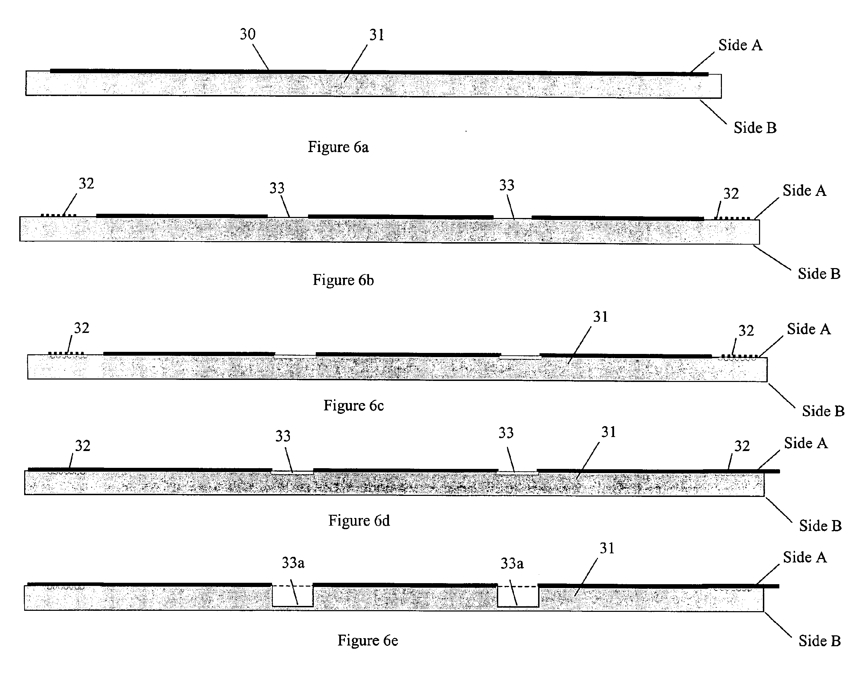

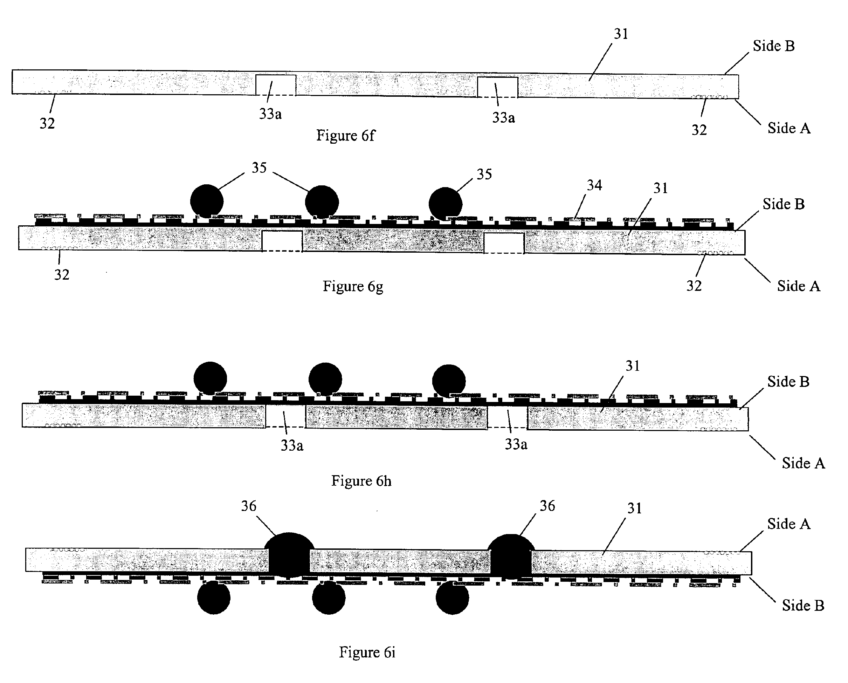

In an embodiment of the invention, the apparatus described in relation to figures 1 to 5 may be used to provide contact bumps, for example of metal, on a first side and a second side of an integrated circuit. An example of a process via which this may be achieved is illustrated schematically in figure 6.

Referring to figure 6a, a layer of resist 30 is provided on a substrate 31. Since the substrate 31 is inverted during the process illustrated in figure 6, sides of the substrate are labelled for ease of reference. The side of the substrate 31 which is provided with a layer of resist in figure 6a (i.e. the front side in figure 6a) is labelled as side A. The side of the substrate 31 which is lowermost in figure 6a (i.e. the back side in figure 6a) is labelled side B.

Referring to figure 6b, alignment marks 32 are exposed in the layer of resist 30, for example using the lithographic apparatus shown schematically in figure 1. In addition, areas at which contact bumps will be located are also exposed. The areas will hereafter be referred to as contact areas 33. It will be appreciated that any suitable lithographic apparatus may be used to expose the alignment marks 32 and contact areas 33. It is not essential that optical lithography is used; for example imprint lithography may be used. Indeed, imprint lithography is well suited in creating the alignment marks 32 and contact areas 33, since these do not need to be aligned with any preceding layers (achieving accurate alignment between layers may be relatively cumbersome using imprint lithography). The alignment marks 32 and contact areas 33 may be exposed (or imprinted) in a single step. Alternatively, they may be exposed (or imprinted) during different steps; for example, the alignment marks 32 may be exposed first and then used to determine the correct location at which to expose the contact areas 33.

Referring to figure 6c, the exposed resist is developed, for example in a conventional manner. Etching of the resist then takes place, for example using conventional etching chemicals. The chemicals etch into the resist only at locations at which the resist has been exposed. In the embodiment shown, the etching is performed for a relatively short period of time, such that the distance etched into the substrate 31, as measured from the upper surface of the unexposed resist, is for instance 160 nanometres.

The alignment marks 32 are covered with a layer of resist, as shown in figure 6d. Following this, the substrate 31 is again etched, the etching on this occasion occurring only at the locations of the contact areas 33 (etching does not occur at the alignment marks 32 since at these locations the resist is unexposed). In the embodiment shown, etching is continued until it has passed through the majority of the substrate 31, for example until a thickness of less than 100 microns of the substrate remains. In an embodiment, the thickness of the remaining substrate is less than 50 microns, e.g. less than 20 microns. The contact areas 33, following etching, will be referred to as the contact recesses 33a, and are shown in figure 6e.

The substrate 31 is inverted (flipped) so that side B becomes the front side of the substrate 31, as shown in figure 6f. Following this, the substrate 31 is introduced (or reintroduced) into the lithographic apparatus described above in relation to figures 1 to 5. The lithographic apparatus is used to project patterned layers onto side B of the substrate 31. Alignment of the patterned layers is to the alignment marks 32 on side A of the substrate 31, which is now the back side of the substrate. The manner in which alignment to the alignment marks 32 is achieved is described above in relation to equivalent alignment marks WM1, WM2.

Since the patterned layers provided on the upper surface of the substrate 31 are aligned to the alignment marks 32 on the backside of the substrate, they are also aligned with respect to the contact recesses 33a in the backside of the substrate. This allows suitable parts of the pattern to be located directly above the contact recesses 33a. For example, regions of the pattern to which it is desired to provide contacts may be located directly above the contact recesses 33a.

It will be appreciated that several patterned layers 34 may be provided on the front side (side B) of the substrate 31, for example as shown in figure 6g. As previously mentioned, each of these layers may be aligned to the alignment marks 32 provided on the back side (side A) of the substrate 31. Alternatively, or additionally, some of the patterned layers may be aligned to alignment marks which are provided upon the upper side (side B) of the substrate. Suitable alignment marks may be provided during exposure of one or more of the patterned layers onto the upper side of the substrate 31.

Once exposure and processing of the patterned layers has been completed, bumps of a conducting material 35, e.g. solder, may be provided at suitable locations upon the front side (side B) of the substrate 31. The bumps of solder are made by providing a thick layer of resist on top of the patterned layers, then exposing the resist using for example the lithographic apparatus described above in relation to figures 1 to 5, the resist being exposed at locations at which bumps of solder are to be provided. Etching is then used to remove the exposed resist in a conventional manner. Solder is electroplated onto the substrate, and is processed in a conventional manner so that only solder which is located in the etched recesses remains. The resist is then stripped from the substrate in a conventional manner, to leave blocks of solder which project upwards from the substrate. The solder is then heated for a limited period of time, so that it melts into a spherical shape and then hardens. This is also referred to as re-flowing the solder. The resulting spherical contact bumps 35 are shown in figure 6g.

Referring to figure 6h, etching is used to remove the thickness of substrate 31 which remains within the contact recesses 33a. As a result of this, an underside of the lowermost patterned layer is exposed. The substrate 31 is then inverted (side A is now located on top of side B). Solder is electroplated onto the front side (side B) of the substrate 31 and is then processed such that any solder which is located within the contact recesses 33a remains, together with a small portion which protrudes above the contact recesses. These will be referred to as contact bumps 36, and are shown in Figure 6i. As evident from Figure 6, the contact bumps on one side of the substrate may be separated by the device layers from the contact bumps on the other side of the substrate. Also, a contact bumps on one side of the substrate does not need to be exactly opposite of a contact bump on the other side of the substrate.

The substrate 31 may be packaged by locating it within packaging which has conducting legs that connect to the spherical contact bumps 35 on side A of the substrate 31, and to the contact bumps 36 provided on side B of the substrate. This may be achieved for example by providing two bases, each of which has conducting legs and associated contact areas, a first base being fixed to side A of the substrate 31, and a second base being fixed to side B of the substrate.

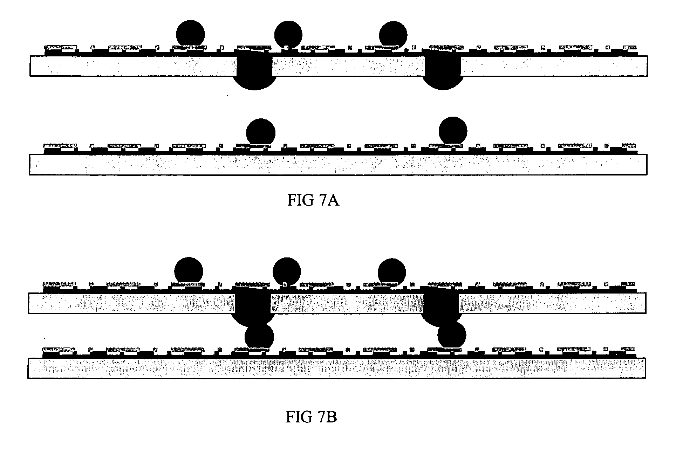

Providing contacts on both sides of the substrate 31 has among its advantages that it allows more connections to the substrate to be obtained. Furthermore, it also allows for more than one substrate to be bonded together, with contacts from each substrate connecting with one another such that integrated circuits provided on the substrates are in electrical communication with each other. See, e.g., Figures 7A,B.

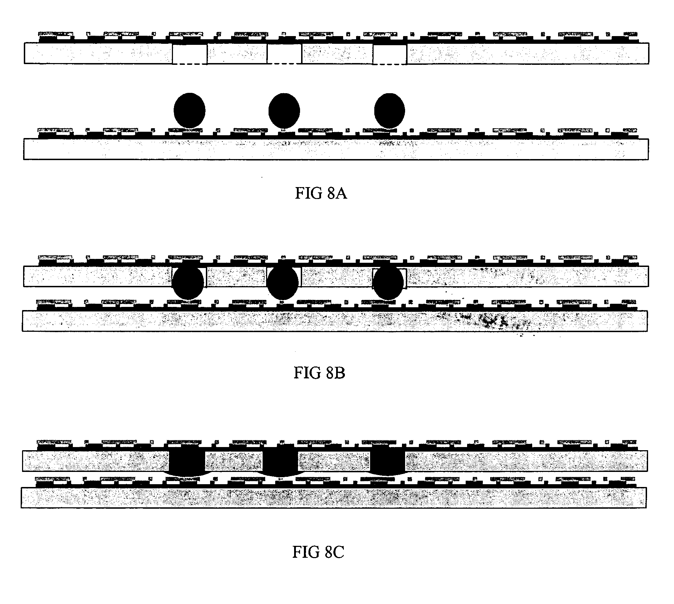

A further embodiment is depicted in Figures 8A,B,C. In Figure 8A, a first substrate is provided with contact bumps and a second substrate is provided with recesses. The recesses are aligned with respect to the bumps and in Figure 8B the recesses are placed over the bumps. Figure 8C represents a situation where the bumps subsequently underwent a heating procedure. Although the embodiment shown in Figures 7 and 8 concern 2 substrates/microdevices, it will be appreciated that the invention allows for the stacking of more substrates/microdevices. For instance, in Figure 8 the second substrate may be provided with bumps on the surface facing away from the recesses, and a third substrate having recesses may be placed over the second substrate in a similar manner as the second substrate is placed over the first substrate.

Although the invention has been described mainly with solder being used to make the contacts, it will be appreciated that any suitable conducting material may be used to make the contacts (for example gold or another suitable metal may be used). Also, although the invention has been described mainly with spherically shaped bumps, it will be appreciated that any suitable shape may be used, e.g. a polygonal shape such as a rectangular shape or square shape.

Although the embodiment of the invention has been described with the steps illustrated in figures 6a to 6i being performed in a particular order, it will be appreciated that the steps may be performed in different orders. For example, the etching of the contact recesses 33a may be performed after the patterned layers 34 have been provided on the substrate 31. Where this is done, the contact recesses 33a may be etched through to one of the patterned layers 34 (ordinarily this would be the first patterned layer to have been provided on the substrate 31). Other changes of the order in which the steps may be performed will be apparent to those skilled in the art.

Where three or more substrates are sandwiched together, there may be no direct access available to the microdevice, e.g. integrated circuit, provided on the middle substrate. For this reason it is desired that the upper and lower microdevices are configured to allow suitable access to the middle microdevice via suitably positioned contacts. For example, a voltage source may be connected to the middle microdevice via a connection from one of the outer microdevices.

Although specific reference may be made to the use of lithographic apparatus in the manufacture of ICs, it should be understood that the system described herein may in some instances have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 436, 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

Other embodiments, uses and advantages of the invention will be apparent to those skilled in the art from consideration of the specification and practice of the invention disclosed herein. The specification should be considered exemplary only, and the scope of the invention is accordingly intended to be limited only by the following claims.

## Claims

1. A microdevice having at least two sides that are provided with contact bumps.

2. The microdevice of claim 1, wherein said microdevice is an integrated circuit.

3. The microdevice of claim 1, wherein said contact bumps comprise solder.

4. The microdevice of claim 1, wherein said contact bumps comprise gold.

5. The microdevice of claim 1, wherein said contact bumps are substantially spherical.

6. A casing comprising the microdevice of claim 1, the casing being provided with metal legs.

7. The casing of claim 6, wherein the metal legs are in contact with the contact bumps.

8. A process comprising stacking two or more microdevices, at least one of said two or more microdevices being a microdevice having at least two sides that are provided with contact bumps.

9. A stack of microdevices comprising a first microdevice and a second microdevice, the first and second microdevice being connected through contact bumps.

10. The stack of claim 9, wherein the first and second microdevice each comprise at least one side provided with contact bumps, and wherein contact bumps on a side of the first microdevice are connected to contact bumps provided on a side of the second microdevice.

11. The stack of claim 9, wherein
the first microdevice comprises a side provided with contact bumps,
the second microdevice is provided on a substrate having recesses provided on a side facing away from the second microdevice, and
the contact bumps reach the second microdevice through the one or more recesses.

12. The stack of claim 9, wherein more than two microdevices are stacked.

13. A method of fabricating an integrated circuit, the method comprising:
providing alignment marks on a first side of a substrate;
providing a plurality of patterned layers on a second side of the substrate, the patterned layers together forming an integrated circuit, the patterned layers being aligned with respect to the alignment marks;
etching recesses on the first side of the substrate, the recesses being aligned with respect to the alignment marks, the recesses being etched through until the first patterned layer is exposed; and
providing contact bumps within the recesses which are in contact with the first patterned layer.

14. A method according to claim 13, wherein the alignment marks and the locations at which the recesses are to be etched are defined during the same lithographic step.

15. A method according to claim 13, wherein the alignment marks and the locations at which the recesses are to be etched are defined during separate lithographic steps.

16. A method according to claim 13, wherein the recesses are etched prior to providing the patterned layers on the second surface of the substrate, the etching passing more than halfway through the substrate.

17. A method according to claim 13, wherein the recesses are etched after providing the patterned layers on the second surface of the substrate, the etching passing through to the one of the patterned layers.

18. A method according to claim 13, wherein contact bumps are also provided on the first side of the substrate.

19. A method according to claim 13, wherein the alignment of the plurality of patterned layers on the second side of the substrate to the alignment marks on the first side of a substrate is achieved using an alignment system which comprises an alignment detector located above second side of the substrate, and an optical system arranged to allow the alignment detector to be in optical communication with the alignment marks.

20. A substrate provided with a plurality of patterned layers which together form an integrated circuit, the substrate further being provided with a set of contact bumps located in recesses in the substrate such that they are in electrical contact with an innermost patterned layer.

21. A substrate according to claim 20, the substrate being provided with a second set of contact bumps, the second set of contact bumps being located on top of an outermost patterned layer, and being in electrical contact therewith.

22. A substrate according to claim 21, wherein the substrate is one of a plurality of substrates, the substrates being in electrical communication with one another through respective contact bumps connect with one another.
